# EUROPEAN PATENT SPECIFICATION

(11) **EP 0 649 562 B1**
(45) Date of publication and mention of the grant of the patent: **04.03.1998**
(21) Application number: 93917069.2
(22) Date of filing: 08.07.1993
(51) Int. Cl.: H01C 1/14, H01C 1/01, H01C 17/00, H05K 1/18

(54) **Circuit protection device**
Schaltungsschutzeinrichtung
Dispositif de protection de circuits

(30) Priority: 09.07.1992 US 910950
(43) Date of publication of application: 26.04.1995
(60) Divisional application: 97202527.4
(73) Proprietor: RAYCHEM CORPORATION, Menlo Park, CA 94025-1164 (US)
(72) Inventor: GRAVES, Gregory, A., Troy, MI 48098 (US); ZHANG, Michael, Fremont, CA 94555 (US); CHANDLER, Daniel, Menlo Park, CA 94025 (US); CHANG, Chi-Ming Dep.of Chemical Engineering, Clear Water Bay Kowloon (HK); FANG, Shou-Mean, Union City, CA 94587 (US)
(74) Representative: Jones, David Colin
(86) International application number: US9306480
(87) International publication number: WO9401876

(56) References cited:
- EP-A- 0 308 306
- EP-A- 0 398 811
- DE-A- 3 839 868
- GB-A- 1 415 454
- US-A- 3 497 859

## Description

This invention relates to circuit protection devices which comprise two laminar electrodes and, sandwiched between the electrodes, a laminar resistive element which exhibits PTC behavior.

Such laminar devices can sometimes be used without the addition of electrical leads, for example by installation between two spring-loaded terminals. DE-A-3839868 (and equivalent U.S. Patent No. 4,924,204) describe such laminar devices in which the PTC element is composed of a conductive polymer, i.e. a composition comprising a polymer and, dispersed therein, a particulate conductive filler. The devices disclosed in DE-A-3839868 are electrically connected to other components of a circuit through terminal members which elastically engage "non-electrode regions" of the device, each of the non-electrode regions comprising one only of the two electrodes and a corresponding portion of the PTC element. In most cases, however, an electrical lead is secured to each of the laminar electrodes, so that the device can be connected to other components of a circuit. The addition of leads is an additional expense and usually involves heating (e.g. during soldering or welding) which can cause damage, particularly to conductive polymer elements. The latter problem is particularly severe when a conductive polymer is heated a second time when the leads are connected to other circuit elements, in particular when the leads are connected to a printed circuit board by a soldering process. A further problem which can arise when such devices are to be mounted on a printed circuit board is that they protrude further from the board than is desirable.

In one aspect, the present invention provides circuit protection devices which have a resistance at 23°C of less than 50 ohms and which comprise
(1) a first laminar electrode (13),
(2) a second laminar electrode (15), and
(3) a laminar resistive element (61) which is composed of a PTC conductive polymer, and which has a first face to which the first electrode is secured and an opposite second face to which the second electrode is secured;
the device comprising
(a) a main portion (11, C-D) which comprises
   (i) a main part of the first electrode (13),
   (ii) a main part of the second electrode (15), and
   (iii) a main part of the resistive element (61);
   and
(b) a first connection leg (19) which extends away from the main portion and which comprises
   (i) a first leg part of the first electrode (13) which is integral with the main part of the first electrode (13), and
   (ii) a first leg part of the resistive element (61) which is integral with the main part of the resistive element (61);
   said first connection leg (19) comprising
   (i) a first distal sub-portion (21) which
      (a) is spaced away from the main portion of the device,
      (b) comprises a first distal sub-part of the first leg part of the first electrode (13),
      (c) comprises a first electrical connector (51) which contacts the first distal sub-part of the first electrode (13) and extends at least to the second face of the laminar resistive element (61), and
      (d) comprises a second residual conductive member (49) which is on the second face of the first leg part of the resistive element (61),
      and
(ii) a first bridge sub-portion (25, D-E) which
   (a) lies between the first distal sub-portion (21) and the main portion (11, C-D) of the device,
   (b) extends across the width of the first connection leg, and
   (c) does not include any part of the second electrode (15);
   the second residual conductive member (49) being a member which is separated from the second electrode (15) and which, in the absence of the first bridge sub-portion (25, D-E), would be integral with the second electrode;
whereby the device can be placed flat on a planar insulating substrate (9) having first and second appropriately spaced-apart metal conductors (41,43) on the surface thereof, with the first electrical connector (51) against the first metal conductor (41); and electrical connection can be made (a) between the first metal conductor (41) and the first electrode (13), through the first electrical connector (51), and (b) between the second conductor (43) and the second electrode (15).

These devices are particularly useful for mounting parallel to a printed circuit board or the like. Thus in a second aspect, the present invention provides an electrical assembly which comprises
(A) a planar insulating substrate (9);
(B) a first metal conductor (41) secured to the insulating substrate (9);
(C) a second metal conductor (43) secured to the insulating substrate (9); and
(D) a circuit protection device as defined in the first aspect of the invention;
the device being placed generally parallel to the planar insulating substrate (9) with the second electrode (15) being closer to the substrate than the first electrode (13), the first electrical connector (51) being connected to the first metal conductor (41); and the second conductor (43) being connected to the second electrode (15).

The novel devices of the invention can be made by cutting out a plurality of laminated articles of the desired final shape or shapes from a simple laminate of constant cross-section, after removing from the laminate unwanted portions of one or both of the electrodes, and then providing the first electrical connector thereon. The removal of unwanted parts of the electrode(s) can be effected for example by milling or by etching. Preferably such removal removes little or none of the PTC resistive element, which provides desirable physical strength to the connection leg.

The PTC compositions used in the present invention are preferably conductive polymers which comprise a crystalline polymer component and, dispersed therein, carbon black. The filler component may also contain a non-conductive filler, which changes not only the electrical properties of the conductive polymer but also its physical properties. Suitable conductive polymers for use in this invention are disclosed for example in U.S. Patent Nos. 4,237,441 (van Konynenburg et al), 4,304,987 (van Konynenburg), 4,388,607 (Toy et al), 4,514,620 (Cheng et al), 4,534,889 (van Konynenburg et al), 4,545,926 (Fouts et al), 4,560,498 (Horsma et al), 4,591,700 (Sopory), 4,724,417 (Au et al), 4,774,024 (Deep et al), 4,935,156 (van Konynenburg), and 5,049,850 (Evans et al).

The resistive element can be composed of one or more conductive polymer members, at least one of which is a PTC member. When there is more than one conductive polymer member, the current preferably flows sequentially through the different compositions, as for example when each composition is in the form of a layer which extends across the whole of the main portion of the device. When there is a single PTC composition, and the desired thickness of the PTC element is greater than that which can conveniently be prepared in a single step, a PTC element of the desired thickness can conveniently be prepared by joining together, e.g. laminating by means of heat and pressure, two or more layers, e.g. melt-extruded layers, of the PTC composition. When there is more than one PTC composition, the PTC element will usually be prepared by joining together, e.g. laminating by means of heat and pressure, elements of the different compositions. For example, a PTC element can comprise two laminar elements composed of a first PTC composition and, sandwiched between them, a laminar element composed of a second PTC composition having a higher resistivity than the first.

When a PTC device is tripped, most of the voltage dropped over the device is normally dropped over a relatively small part of the device which is referred to as the hot line, hot plane or hot zone. In the devices of the invention, the PTC element can have one or more features which help the hot line to form at a desired location, usually spaced apart from both electrodes. Suitable features of this kind for use in the present invention are disclosed for example in U.S. Patents Nos. 4,317,027 and 4,352,083 (Middleman et al), 4,907,340 and 4,924,072 (Fang et al).

Particularly useful devices of the invention comprise two metal foil electrodes, and a PTC conductive polymer element sandwiched between them, especially such devices which have a resistance at 23°C of less than 10 ohm, particularly less than 5 ohm, especially less than 3 ohm. Particularly suitable foil electrodes are disclosed in U.S. Patents Nos. 4,689,475 (Matthieson) and 4,800,253 (Kleiner et al). A variety of laminar devices which can be modified in accordance with the present invention are disclosed in U.S. Patent Nos. 4,238,812 (Middleman et al), 4,255,798 (Simon), 4,272,471 (Walker), 4,315,237 (Middleman et al), 4,317,027 (Middleman et al), 4,330,703 (Horsma et al), 4,426,633 (Taylor), 4,475,138 (Middleman et al), 4,472,417 (Au et al), 4,780,598 (Fahey et al), 4,845,838 (Jacobs et al), 4,907,340 (Fang et al), and 4,924,074 (Fang et al).

The first electrical connector is preferably one which will remain in place even if it is not bonded to the other parts of the device, for example a U-shaped member which extends around the end of the first leg portion and the first electrode and contacts the first electrode and the second residual conductive member. The connector can be resilient so that it clamps to the remainder of the device.

So that the device can be placed either way up on the substrate, and/or so that it has balanced electrical properties, the device can also contain a second connection leg (27) which extends away from the main portion (11, C-D) of the device; which is spaced apart from the first connection leg; and which comprises
(i) a second leg part of the second electrode (15) which is integral with the main part of the second electrode, and
(ii) a second leg part of the resistive element (61) which is integral with the main part of the resistive element (61);
said second connection leg (27) comprising
(i) a second distal sub-portion (31) which
   (a) is spaced apart from the main portion (11, C-D) of the device,
   (b) comprises a second distal sub-part of the second leg part of the second electrode (15); and
   (c) comprises a second electrical connector (53) which contacts the second distal sub-part of the second electrode (15) and extends at least to the first face of the laminar resistive element (61);
   and
(ii) a second bridge sub-portion (33, B-C) which
   (a) lies between the second distal sub-portion (31) and the main portion (11, C-D) of the device,
   (b) extends across the width of the second connection leg (27), and
   (c) does not include any part of the first electrode (13);
whereby the device can be placed flat on a planar insulating substrate (9) having first and second appropriately spaced apart metal conductors (41,43) on the surface thereof, with either the first electrical connector (51) or the second electrical connector (53) against one of the metal conductors (41 or 43), and electrical connection can be made (a) between said electrical connector (51 or 53) and said metal conductor (41 or 43) and (b) between the other metal conductor (43 or 41) and the electrode (13 or 15) adjacent to the substrate.

The preferred characteristics of the second distal and bridge sub-portions and the second connector are substantially the same as previously described for the first distal and bridge sub-portions and the first connector.

In the devices of the invention, the contacting surfaces are preferably coated with solder or tin, or otherwise treated, so that they can all be soldered together in a single step by exposing them to heat. Correspondingly, in the assemblies of the second aspect of the invention, there is preferably a solder joint between each of
(a) the first electrical connector and the first electrode,
(b) the first electrical connector and the first metal conductor, and
(c) the second electrode and the second metal conductor, or between the second electrode and an intermediate connector and between the intermediate connector and the second metal conductor, the intermediate connector lying between the second electrode and the second metal conductor.

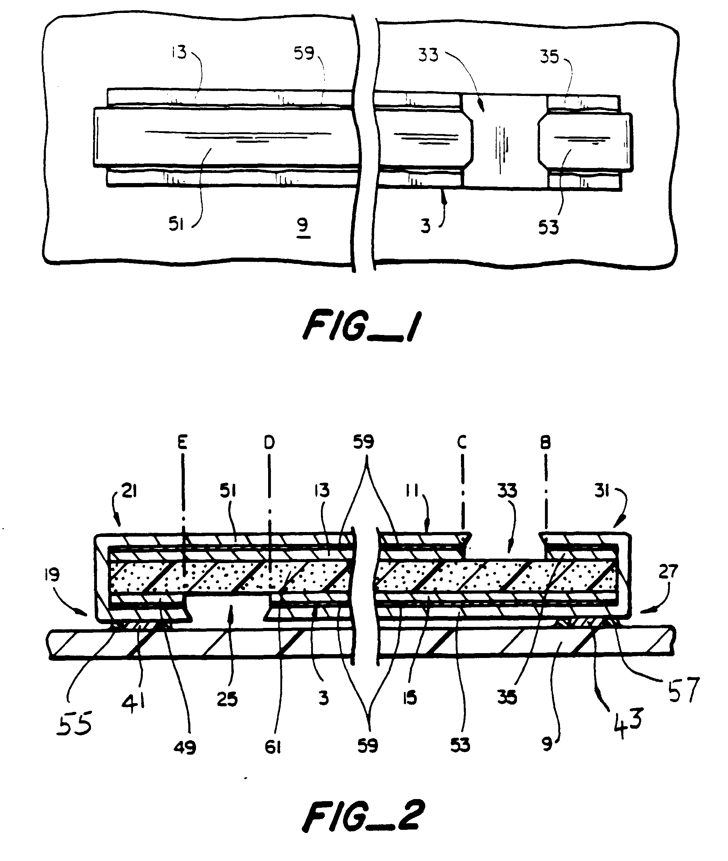

The invention is illustrated by the drawings in which Figure 1 is a top view of an assembly of the invention and Figure 2 is a cross-sectional view through the thickness of the assembly of Figure 1. In this assembly, the protection device comprises a laminar resistive element 61 which is laminated to the main portion of the first electrode 13 and the first residual conductive member 35 and to the main portion of the second electrode 15 and the second residual conductive member 49. (The main portion 11 of the device lies between lines C and D.) Attached to first connection leg 19 around first distal sub-portion 21 is U-shaped first connector 51. Attached to second connection leg 27 around second distal sub-portion 31 is U-shaped second connector 53. A solder joint 59 lies between the periphery of the first connector 51 and the first electrode 13 and between the periphery of the second connector 53 and the second electrode 15. First bridge sub-portion 25 lies between lines D and E and second bridge sub-portion 33 lies between lines B and C. Electrical connection is made from the first connector 51 to a first metal conductor 41 secured to insulating substrate 9 by means of first solder joint 55, and from the second connector 53 to second metal conductor 43 secured to the insulating substrate 9 by means of second solder joint 57.

## Claims

1. A circuit protection device which has a resistance at 23°C of less than 50 ohms and which comprises
(1) a first laminar electrode (13),
(2) a second laminar electrode (15), and
(3) a laminar resistive element (61) which is composed of a PTC conductive polymer, and which has a first face to which the first electrode is secured and an opposite second face to which the second electrode is secured;
the device comprising
(a) a main portion (11, C-D) which comprises
(i) a main part of the first electrode (13),
(ii) a main part of the second electrode (15), and
(iii) a main part of the resistive element (61);
and
(b) a first connection leg (19) which extends away from the main portion and which comprises
(i) a first leg part of the first electrode (13) which is integral with the main part of the first electrode (13), and
(ii) a first leg part of the resistive element (61) which is integral with the main part of the resistive element (61);
said first connection leg (19) comprising
(i) a first distal sub-portion (21) which
(a) is spaced away from the main portion of the device,
(b) comprises a first distal sub-part of the first leg part of the first electrode (13),
(c) comprises a first electrical connector (51) which contacts the first distal sub-part of the first electrode (13) and extends at least to the second face of the laminar resistive element (61), and
(d) comprises a second residual conductive member (49) which is on the second face of the first leg part of the resistive element (61),
and
(ii) a first bridge sub-portion (25, D-E) which
(a) lies between the first distal sub-portion (21) and the main portion (11, C-D) of the device,
(b) extends across the width of the first connection leg, and
(c) does not include any part of the second electrode (15);
the second residual conductive member (49) being a member which is separated from the second electrode (15) and which, in the absence of the first bridge sub-portion (25, D-E), would be integral with the second electrode;
whereby the device can be placed flat on a planar insulating substrate (9) having first and second appropriately spaced-apart metal conductors (41,43) on the surface thereof, with the first electrical connector (51) against the first metal conductor (41); and electrical connection can be made (a) between the first metal conductor (41) and the first electrode (13), through the first electrical connector (51), and (b) between the second conductor (43) and the second electrode (15).

2. A device according to claim 1 wherein the first electrical connector (51) is a U-shaped member (51) which extends around the end of the first connection leg (19) and contacts the first electrode (13) and the second residual conductive member (49).

3. A device according to claim 1 or 2 which also contains
a second connection leg (27) which extends away from the main portion (11, C-D) of the device; which is spaced apart from the first connection leg; and which comprises
(i) a second leg part of the second electrode (15) which is integral with the main part of the second electrode, and
(ii) a second leg part of the resistive element (61) which is integral with the main part of the resistive element (61);
said second connection leg (27) comprising
(i) a second distal sub-portion (31) which
(a) is spaced apart from the main portion (11, C-D) of the device,
(b) comprises a second distal sub-part of the second leg part of the second electrode (15); and
(c) comprises a second electrical connector (53) which contacts the second distal sub-part of the second electrode (15) and extends at least to the first face of the laminar resistive element (61);
and
(ii) a second bridge sub-portion (33, B-C) which
(a) lies between the second distal sub-portion (31) and the main portion (11, C-D) of the device,
(b) extends across the width of the second connection leg (27), and
(c) does not include any part of the first electrode (13);
whereby the device can be placed flat on a planar insulating substrate (9) having first and second appropriately spaced apart metal conductors (41,43) on the surface thereof, with either the first electrical connector (51) or the second electrical connector (53) against one of the metal conductors (41 or 43), and electrical connection can be made (a) between said electrical connector (51 or 53) and said metal conductor (41 or 43) and (b) between the other metal conductor (43 or 41) and the electrode (13 or 15) adjacent to the substrate.

4. A device according to any one of the preceding claims which has a resistance of less than 3 ohm and in which each of the laminar electrodes (13,15) is a metal foil.

5. A device according to any one of the preceding claims wherein the PTC conductive polymer comprises a crystalline polymer component and, dispersed therein, carbon black.

6. An electrical assembly which comprises
(A) a planar insulating substrate (9);
(B) a first metal conductor (41) secured to the insulating substrate (9);
(C) a second metal conductor (43) secured to the insulating substrate (9); and
(D) a circuit protection device as claimed in any one of the preceding claims;
the device being placed generally parallel to the planar insulating substrate (9) with the second electrode (15) being closer to the substrate than the first electrode (13), the first electrical connector (51) being connected to the first metal conductor (41); and the second conductor (43) being connected to the second electrode (15).

7. An assembly according to claim 6 wherein there is a solder joint (55,57) between each of
(a) the first electrical connector (51) and the first electrode (13),
(b) the first electrical connector (51) and the first metal conductor (41), and
(c) the second electrode (15) and the second metal conductor (43), or between the second electrode (15) and an intermediate connector which lies between the second electrode and the second metal conductor, and between the intermediate connector and the second metal conductor.

## Patentansprüche

1. Schaltungsschutzvorrichtung, die einen Widerstandswert bei 23 °C von weniger als 50 Ohm hat und die folgendes aufweist:
(1) eine erste laminare Elektrode (13),
(2) eine zweite laminare Elektrode (15) und
(3) ein laminares Widerstandselement (61), das aus einem PTC-leitfähigen Polymer besteht und das eine erste Fläche, an der die erste Elektrode befestigt ist, und eine gegenüberliegende zweite Fläche hat, an der die zweite Elektrode befestigt ist;
wobei die Vorrichtung folgendes aufweist:
(a) einen Hauptbereich (11, C-D), der folgendes aufweist:
(i) ein Hauptteil der ersten Elektrode (13),
(ii) ein Hauptteil der zweiten Elektrode (15) und
(iii) ein Hauptteil des Widerstandselements (61);
und
(b) einen ersten Verbindungsschenkel (19), der sich von dem Hauptbereich weg erstreckt und der folgendes aufweist:
(i) ein erstes Schenkelteil der ersten Elektrode (13), das mit dem Hauptteil der ersten Elektrode (13) integral ausgebildet ist, und
(ii) ein erstes Schenkelteil des Widerstandselements (61), das mit dem Hauptteil des Widerstandselements (61) integral ausgebildet ist;
wobei der erste Verbindungsschenkel (19) folgendes aufweist:
(i) einen ersten distalen Unterbereich (21), der
(a) von dem Hauptbereich der Vorrichtung weg beabstandet ist,
(b) ein erstes distales Unterteil des ersten Schenkelteils der ersten Elektrode (13) aufweist,
(c) einen ersten elektrischen Verbinder (51) aufweist, der mit dem ersten distalen Unterteil der ersten Elektrode (13) in Kontakt steht und sich wenigstens bis zu der zweiten Fläche des laminaren Widerstandselements (61) erstreckt, und
(d) ein zweites leitfähiges Restelement (49) aufweist, das auf der zweiten Fläche des ersten Schenkelteils des Widerstandselements (61) angeordnet ist,
und
(ii) einen ersten Brückenunterbereich (25, D-E), der
(a) zwischen dem ersten distalen Unterbereich (21) und dem Hauptbereich (11, C-D) der Vorrichtung liegt,
(b) sich über die Breite des ersten Verbindungsschenkels erstreckt und
(c) keinen Teil der zweiten Elektrode (15) aufweist;
wobei das zweite leitfähige Restelement (49) ein Element ist, das von der zweiten Elektrode (15) getrennt ist und das bei Abwesenheit des ersten Brückenunterbereichs (25, D-E) mit der zweiten Elektrode integral wäre;
so daß die Vorrichtung flach auf einem planaren isolierenden Substrat (9) plaziert werden kann, das einen ersten und einen zweiten Metalleiter (41, 43) auf seiner Oberfläche hat, die geeignet voneinander beabstandet sind, wobei der erste elektrische Verbinder (51) an dem ersten Metalleiter (41) anliegt, und eine elektrische Verbindung hergestellt werden kann (a) zwischen dem ersten Metalleiter (41) und der ersten Elektrode (13) durch den ersten elektrischen Verbinder (51) und (b) zwischen dem zweiten Leiter (43) und der zweiten Elektrode (15).

2. Vorrichtung nach Anspruch 1,
wobei der erste elektrische Verbinder (51) ein U-förmiges Element (51) ist, das sich um das Ende des ersten Verbindungsschenkels (19) herum erstreckt und mit der ersten Elektrode (13) und dem zweiten leitfähigen Restelement (49) in Kontakt steht.

3. Vorrichtung nach Anspruch 1 oder 2,
die ferner folgendes aufweist:
einen zweiten Verbindungsschenkel (27), der sich von dem Hauptbereich (11, C-D) der Vorrichtung weg erstreckt; der von dem ersten Verbindungsschenkel beabstandet ist; und der folgendes aufweist:
(i) ein zweites Schenkelteil der zweiten Elektrode (15), das mit dem Hauptteil der zweiten Elektrode integral ausgebildet ist, und
(ii) ein zweites Schenkelteil des Widerstandselements (61), das mit dem Hauptteil des Widerstandselements (61) integral ausgebildet ist;
wobei der zweite Verbindungsschenkel (27) folgendes aufweist:
(i) einen zweiten distalen Unterbereich (31), der
(a) von dem Hauptbereich (11, C-D) der Vorrichtung beabstandet ist,
(b) ein zweites distales Unterteil des zweiten Schenkelteils der zweiten Elektrode (15) aufweist; und
(c) einen zweiten elektrischen Verbinder (53) aufweist, der mit dem zweiten distalen Unterteil der zweiten Elektrode (15) in Kontakt steht und der sich wenigstens bis zu der ersten Fläche des laminaren Widerstandselements (61) erstreckt;
und
(ii) einen zweiten Brückenunterbereich (33, B-C), der
(a) zwischen dem zweiten distalen Unterbereich (31) und dem Hauptbereich (11, C-D) der Vorrichtung liegt,
(b) sich über die Breite des zweiten Verbindungsschenkels (27) erstreckt und
(c) keinen Teil der ersten Elektrode (13) aufweist;
so daß die Vorrichtung flach auf einem planaren isolierenden Substrat (9) plaziert werden kann, das einen ersten und einen zweiten Metalleiter (41, 43) auf seiner Oberfläche hat, die geeignet voneinander beabstandet sind, wobei entweder der erste elektrische Verbinder (51) oder der zweite elektrische Verbinder (53) an einem der Metalleiter (41 oder 43) anliegt, und eine elektrische Verbindung hergestellt werden kann (a) zwischen dem elektrischen Verbinder (51 oder 53) und dem Metalleiter (41 oder 43) und (b) zwischen dem anderen Metalleiter (43 oder 41) und der Elektrode (13 oder 15) angrenzend an das Substrat.

4. Vorrichtung nach einem der vorhergehenden Ansprüche, die einen Widerstandswert von weniger als 3 Ohm hat und bei der jede der laminaren Elektroden (13, 15) eine Metallfolie ist.

5. Vorrichtung nach einem der vorhergehenden Ansprüche, wobei das PTC-leitfähige Polymer eine kristalline Polymerkomponente und darin fein verteilt Ruß aufweist.

6. Elektrische Anordnung, die folgendes aufweist:
(A) ein planares isolierendes Substrat (9);
(B) einen ersten Metalleiter (41), der an dem isolierenden Substrat (9) befestigt ist;
(C) einen zweiten Metalleiter (43), der an dem isolierenden Substrat (9) befestigt ist; und
(D) eine Schaltungsschutzvorrichtung nach einem der vorhergehenden Ansprüche;
wobei die Vorrichtung im allgemeinen parallel zu dem planaren isolierenden Substrat (9) angebracht ist, wobei die zweite Elektrode (15) dem Substrat näher ist als die erste Elektrode (13), wobei der erste elektrische Verbinder (51) mit dem ersten Metalleiter (41) verbunden ist; und wobei der zweite Leiter (43) mit der zweiten Elektrode (15) verbunden ist.

7. Anordnung nach Anspruch 6,
wobei eine Lötverbindung (55, 57) vorhanden ist zwischen jedem von
(a) dem ersten elektrischen Verbinder (51) und der ersten Elektrode (13),
(b) dem ersten elektrischen Verbinder (51) und dem ersten Metalleiter (41) und
(c) der zweiten Elektrode (15) und dem zweiten Metallleiter (43) oder zwischen der zweiten Elektrode (15) und einem Zwischenverbinder, der zwischen der zweiten Elektrode und dem zweiten Metalleiter liegt, und zwischen dem Zwischenverbinder und dem zweiten Metallleiter.

## Revendications

1. Dispositif de protection de circuit qui possède une résistance, à 23°C, inférieure à 50 ohms et qui comporte
(1) une première électrode lamellaire (13),
(2) une seconde électrode lamellaire (15), et
(3) un élément résistif lamellaire (61) qui est composé d'un polymère conducteur CTP, et qui présente une première face à laquelle la première électrode est fixée et une seconde face, opposée, à laquelle la seconde électrode est fixée ;
le dispositif comportant
(a) une portion principale (11, C-D) qui comporte
(i) une partie principale de la première électrode (13),
(ii) une partie principale de la seconde électrode (15), et
(iii) une partie principale de l'élément résistif (61) ;
et
(b) une première patte de connexion (19) qui fait saillie à l'écart de la portion principale et qui comporte
(i) une partie de première patte de la première électrode (13) qui est réalisée d'une seule pièce avec la partie principale de la première électrode (13), et
(ii) une partie de première patte de l'élément résistif (61) qui est réalisée d'une seule pièce avec la partie principale de l'élément résistif (61) ;
ladite première patte de connexion (19) comportant
(i) une première portion secondaire distale (21) qui
(a) est espacée de la portion principale du dispositif,
(b) comporte une première partie secondaire distale de la partie de première patte de la première électrode (13),
(c) comporte un premier connecteur électrique (51) qui est en contact avec la première partie secondaire distale de la première électrode (13) et qui s'étend au moins jusqu'à la seconde face de l'élément résistif lamellaire (61), et
(d) comporte un second élément conducteur résiduel (49) qui est situé sur la seconde face de la partie de première patte de l'élément résistif (61),
et
(ii) une première portion secondaire de pont (25, D-E) qui
(a) s'étend entre la première portion secondaire distale (21) et la portion principale (11, C-D) du dispositif,
(b) s'étend sur la largeur de la première patte de connexion, et
(c) ne comprend aucune partie de la seconde électrode (15) ;
le second élément conducteur résiduel (49) étant un élément qui est séparé de la seconde électrode (15) et qui, en l'absence de la première portion secondaire de pont (25, D-E), serait réalisé d'une seule pièce avec la seconde électrode ;
grâce à quoi le dispositif peut être placé à plat sur un substrat isolant plan (9) ayant des premier et second conducteurs métalliques (41, 43) espacés de façon appropriée sur sa surface, avec le premier connecteur électrique (51) contre le premier conducteur métallique (41) ; et une connexion électrique peut être réalisée (a) entre le premier conducteur métallique (41) et la première électrode (13), en passant par le premier connecteur électrique (51), et (b) entre le second conducteur (43) et la seconde électrode (15).

2. Dispositif selon la revendication 1, dans lequel le premier connecteur électrique (51) est un élément (51) de forme en U qui s'étend autour de l'extrémité de la première patte (19) de connexion et qui est en contact avec la première électrode (13) et le second élément conducteur résiduel (49).

3. Dispositif selon la revendication 1 ou 2, qui contient aussi
une seconde patte (27) de connexion qui fait saillie à l'écart de la portion principale (11, C-D) du dispositif, qui est espacée de la première patte de connexion, et qui comporte
(i) une partie de seconde patte de la seconde électrode (15) qui est réalisée d'une seule pièce avec la partie principale de la seconde électrode, et
(ii) une partie de seconde patte de l'élément résistif (61) qui est réalisée d'une seule pièce avec la partie principale de l'élément résistif (61) ;
ladite seconde patte de connexion (27) comportant
(i) une seconde portion secondaire distale (31) qui
(a) est espacée de la portion principale (11, C-D) du dispositif,
(b) comporte une seconde partie secondaire distale de la partie de seconde patte de la seconde électrode (15) ; et
(c) comporte un second connecteur électrique (53) qui est en contact avec la seconde partie secondaire distale de la seconde électrode (15) et s'étend au moins jusqu'à la première face de l'élément résistif lamellaire (61) ;
et
(ii) une seconde portion secondaire de pont (33, B-C) qui
(a) s'étend entre la seconde portion secondaire distale (31) et la portion principale (11, C-D) du dispositif,
(b) s'étend sur la largeur de la seconde patte de connexion (27), et
(c) ne comprend aucune partie de la première électrode (13) ;
grâce à quoi le dispositif peut être placé à plat sur un substrat isolant plan (9) ayant des premier et second conducteurs métalliques (41, 43) espacés de façon appropriée sur sa surface, avec soit le premier connecteur électrique (51), soit le second connecteur électrique (53) contre l'un des conducteurs métalliques (41 ou 43), et une connexion électrique peut être réalisée (a) entre ledit connecteur électrique (51 ou 53) et ledit conducteur métallique (41 ou 43) et (b) entre l'autre conducteur métallique (43 ou 41) et l'électrode (13 ou 15) adjacente au substrat.

4. Dispositif selon l'une quelconque des revendications précédentes, qui possède une résistance de moins de 3 ohms et dans lequel chacune des électrodes lamellaires (13, 15) est formée d'une mince feuille de métal.

5. Dispositif selon l'une quelconque des revendications précédentes, dans lequel le polymère conducteur CTP comprend un constituant polymère cristallin et, en dispersion dans celui-ci, du noir de carbone.

6. Ensemble électrique qui comporte
(A) un substrat isolant plan (9) ;
(B) un premier conducteur métallique (41) fixé au substrat isolant (9) ;
(C) un second conducteur métallique (43) fixé au substrat isolant (9) ; et
(D) un dispositif de protection de circuit selon l'une quelconque des revendications précédentes ;
le dispositif étant placé de façon à être globalement parallèle au substrat isolant plan (9), avec la seconde électrode (15) plus proche du substrat que la première électrode (13), le premier connecteur électrique (51) étant connecté au premier conducteur métallique (41), et le second conducteur (43) étant connecté à la seconde électrode (15).

7. Ensemble selon la revendication 6, dans lequel il y a un joint soudé (55, 57) entre chacun de
(a) le premier connecteur électrique (51) et la première électrode (13),
(b) le premier connecteur électrique (51) et le premier conducteur métallique (41), et
(c) la seconde électrode (15) et le second conducteur métallique (43), ou entre la seconde électrode (15) et un connecteur intermédiaire qui s'étend entre la seconde électrode et le second conducteur métallique, et entre le connecteur intermédiaire et le second conducteur métallique.
